(19) Europäisches Patentamt
European Patent Office
Office européen des brevets

(11) **EP 1 198 063 B1**

(12) **EUROPÄISCHE PATENTSCHRIFT**

(45) Veröffentlichungstag und Bekanntmachung des Hinweises auf die Patenterteilung:
**03.03.2004   Patentblatt 2004/10**

(51) Int Cl.[7]: **H03K 17/955**

(21) Anmeldenummer: **01115884.7**

(22) Anmeldetag: **29.06.2001**

(54) **Kapazitiver Näherungssensor**

Capacitive approximation sensor

Détecteur d'approche d'effet capacitif

(84) Benannte Vertragsstaaten:
**AT BE CH CY DE DK ES FI FR GB GR IE IT LI LU MC NL PT SE TR**

(30) Priorität: **11.10.2000   DE 20017457 U**

(43) Veröffentlichungstag der Anmeldung:
**17.04.2002   Patentblatt 2002/16**

(73) Patentinhaber: **DREEFS GmbH Schaltgeräte und Systeme**
**96364 Marktrodach (DE)**

(72) Erfinder: **Peng, Xiaoming, Dr.-Ing.**
**96317 Kronach (DE)**

(74) Vertreter: **Koch, Günther, Dipl.-Ing. et al**
**Garmischer Strasse 4**
**80339 München (DE)**

(56) Entgegenhaltungen:
**FR-A- 2 271 538          US-A- 5 508 700**

- **PATENT ABSTRACTS OF JAPAN vol. 1996, no. 06, 28. Juni 1996 (1996-06-28) & JP 08 054474 A (SEIKOSHA CO LTD), 27. Februar 1996 (1996-02-27)**
- **PATENT ABSTRACTS OF JAPAN vol. 014, no. 061 (P-1001), 5. Februar 1990 (1990-02-05) & JP 01 285801 A (KOKO RES KK), 16. November 1989 (1989-11-16)**

EP 1 198 063 B1

**Beschreibung**

Die Erfindung bezieht sich auf einen Berührungssensor und ein Verfahren sowie eine Schaltungsanordnung zum Erkennen einer Annäherung eines Körpers.

Berührungssensoren, die bei Berührung einer Tastfläche durch einen Finger ansprechen, finden vielfach Verwendung zur Auslösung bestimmter Schaltvorgänge, oder sie sind als Tastatur ausgebildet. Die vorliegende Erfindung bezieht sich auf Berührungssensoren jener Bauart, bei denen eine dielektrische Platte, beispielsweise eine Glasplatte, nur auf der Rückseite eine Elektrode aufweist, während die Tastseite freiliegt und durch die Glasplatte sichtbar ein Anzeigefeld für die jeweilige Tastfunktion sichtbar ist. Derartige Sensoranordnungen werden auch als Tastaturen benutzt.

Das Grundprinzip derartiger Berührungssensoren besteht darin, daß durch die Elektrode eine kapazitive Verbindung zum menschlichen Körper (Finger) hergestellt wird, und diese Verbindung schließt zusammen mit der überwiegend kapazitiven Kopplung einen kapazitiven Stromkreis, der einem Hochpaß entspricht. Die Kapazitätsänderung bei Berührung wird als Anzeigekriterium benutzt.

Ein derartiger Berührungssensor ist aus der EP 0 802 500 bekannt. Hierbei wird ein Testsignal zwischen Erde und Schaltungsmasse erzeugt, und dieses Signal wird über kapazitive Kopplung über den menschlichen Körper (Finger) in die Basis eines Transistors eingekoppelt. Für die Funktion dieser Schaltungsanordnung ist ein Erdanschluß zwingend erforderlich, da das Testsignal zwischen Erde und Schaltungsmasse eingeführt wird.

Die WO 96/13 098 beschreibt einen Berührungssensor mit zwei Elektroden hinter einer dielektrischen Platte, wobei die beiden Elektroden konzentrisch zueinander angeordnet sind. Durch Berührung mit dem Finger wird die Kapazität zwischen den Elektroden geändert, was in der Schaltung ausgewertet wird.

Die FR-A-2 271 538 zeigt einen kapazitiven Annäherungssensor mit einer Berührungselektrode, die mit der Basis eines Transistors verbunden ist, dessen Kollektor über einen Widerstand an Spannung liegt und über dessen Basis-Emitterstrecke ein Widerstand liegt. Am Emitter liegt eine Impulsspannung in Form von periodischen negativen Spannungsspitzen an, die aus einer Rechteckimpulsfolge über einen Differentiator erzeugt wird. Die Impulsspitzen haben eine zur. Versorgungsspannung $V_{cc}$ entgegengesetzte Polarität.

Der Erfindung liegt die Aufgabe zugrunde, eine Schaltung für einen kapazitiven Näherungssensor anzugeben, bei der die Empfindlichkeit und Störfestigkeit gegenüber bekannten Systemen beträchtlich verbessert ist, ohne daß ein Erdanschluß erforderlich ist und ohne mehrere Elektroden am Dielektrikum vorzusehen.

Gelöst wird die gestellte Aufgabe durch die Gesamtheit der im Patentanspruch 1 angegebenen Merkmale. Die erfindungsgemäße Schaltung weist einen einfachen und kostengünstigen Aufbau auf und bietet einen guten Schutz gegen Feuchtigkeit und Schmutz.

Nach der Erfindung wird die Elektrode direkt hinter der Tastaturblende, d.h. hinter einer dielektrischen Platte, beispielsweise einer Glasplatte, angebracht. Sie kann z.B. eine Kupferfläche einer herkömmlichen Leiterplatte sein, auf der die weiteren Bauteile der Auswerteelektronik untergebracht sind. Das Dielektrikum kann plattenförmig, beispielsweise aus Glas, Plexiglas, Kunststoff, Stein oder Holz, ausgebildet sein.

Ein weiterer Vorteil der Erfindung besteht darin, daß die die Gesamtkapazität beeinflussenden Faktoren, die zeitlich und räumlich variabel sind, berücksichtigt werden können. Dazu zählen noch die normalen Wertstreuungen und die Temperaturabhängigkeit der elektronischen Bauteile. Diese Faktoren können dazu führen, daß die Impulshöhen (Empfindlichkeiten) zwischen verschiedenen Tasten einer Tastatur und mit zeitlicher und räumlicher Anordnung variieren können. Die Erfindung ermöglicht eine "schwimmende" Festlegung des Schwellenwerts. Dabei kann jeweils die Spitzenspannung gemessen und gespeichert werden, wodurch räumlich und zeitlich sich langsam verändernde Faktoren ständig ausgeglichen werden. Eine rasche Veränderung des Wertes um eine vorgegebenen Schwelle signalisiert dann die Kapazitätsänderung durch Berührung mit dem Finger.

Weitere Ausgestaltungen der Erfindung ergeben sich aus den Unteransprüchen und der Beschreibung von Ausführungsbeispielen.

Nachstehend werden Ausführungsbeispiele der Erfindung anhand der Zeichnung beschrieben. In der Zeichnung zeigen:

Fig. 1     zeigt eine schematische Darstellung der erfindungsgemäßen Schaltungsanordnung eines Berührungssensors;

Fig. 2     zeigt eine Schaltungsanordnung, bei welcher die in Fig. 1 angegebenen Teilkapazitäten zu einem äquivalenten Kondensator $C_1$ zusammengefaßt sind;

Fig. 3     zeigt ein Diagramm der bei der Schaltungsanordnung gemäß Fig. 1 und 2 auftretenden Spannungen im Zustand ohne Berührung und mit Berührung;

Fig. 4     ist ein Schaltbild einer Schaltungsanordnung mit sich selbsttätig einstellenbarem Schwellwert;

Fig. 5     zeigt ein Diagramm der bei der Schaltungsanordnung gemäß Fig. 4 auftretenden Spannungen im Zustand ohne Berührung und mit Berührung;

Fig. 6    zeigt eine Schaltungsanordnung eines Multiplexverfahrens für ein Tastenfeld mit mehreren
Berührungssenoren.

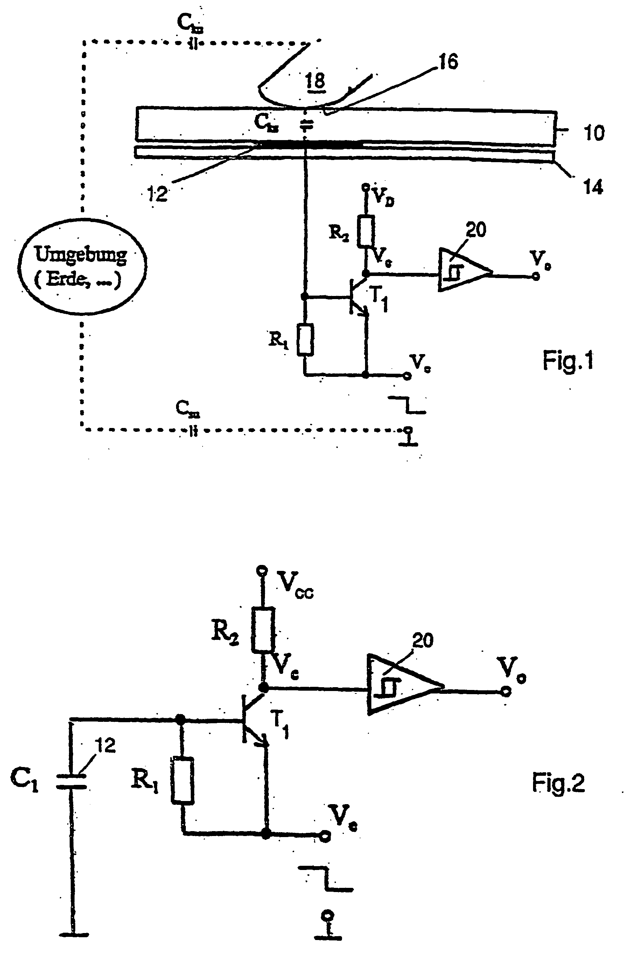

Fig. 1 zeigt eine dielektrische, beispielsweise aus Glas bestehende, Platte 10, die auf der unteren Seite eine Elektrode 12 aufweist, die auf einer unter der Glasplatte 10 angeordneten Leiterplatte 14 angeordnet sein kann. Die obere Oberfläche der Glasplatte 10 bildet die Sensorfläche 16, die vom Finger 18 des Benutzers an einer entsprechend gekennzeichneten Stelle über der aus einer Kupferfläche der Leiterplatte 14 bestehenden Elektrode 12 berührt wird.

Der menschliche Körper besitzt stets eine Kapazität gegenüber seiner Umgebung (Erde), die in Fig. 1 mit $C_{ku}$ bezeichnet ist. Weiter besteht eine Kapazität $C_{su}$ zwischen der Schaltung (Leiterplatte) und der Umgebung (Erde). Ein Kondensator $C_{ks}$ wird zwischen der Elektrode 12 und dem Finger 18 des Benutzers gebildet. In Fig. 2 sind die Kapazitäten $C_{ks}$, $C_{ku}$ und $C_{su}$ zu einem Kondensator $C_1$ zusammengefaßt. Somit wird die Kapazität des Kondensators $C_1$ abhängig von dem Abstand zwischen der Elektrode 12 und dem menschlichen Körper (Finger 18).

Um die durch die Annäherungsbedingung des Fingers 18 an der Glasplatte 10 bedingte Kapazitätsänderung erfassen zu können, ist eine Auswerteschaltung gemäß Fig. 1 bzw. 2 vorgesehen. Die Elektrode 12 ist mit der Basis eines Transistors $T_1$ verbunden, der räumlich möglichst nahe an der Elektrode 12 angeordnet ist, damit der Kapazitätsanteil der Leitungsführung vermindert und das Lokalisieren des Sensibilisierungsbereichs verbessert wird. Gemäß dem dargestellten Schaltungsbeispiel ist der Transistor $T_1$ als NPN-Transistor ausgebildet, es kann jedoch ein PNP-Transistor, ein Feldeffekt-Transistor oder ein anderes aktives Bauteil sein, welches eine Verstärkungseigenschaft, eine Spannung-Strom-Umwandlungseigenschaft oder eine Triggerbarkeit besitzt.

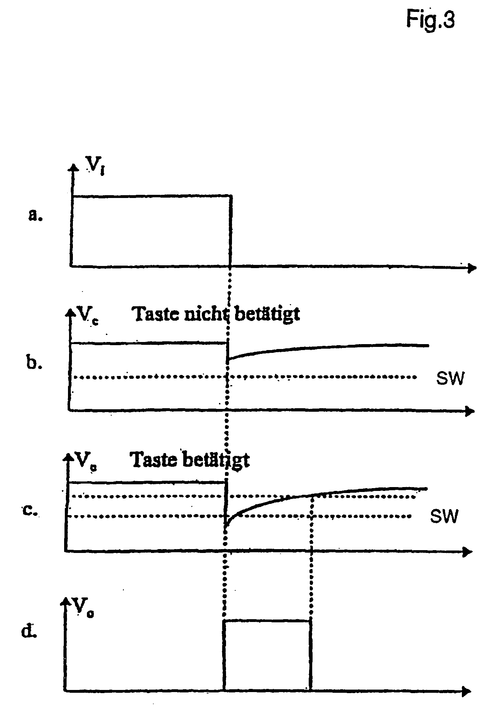

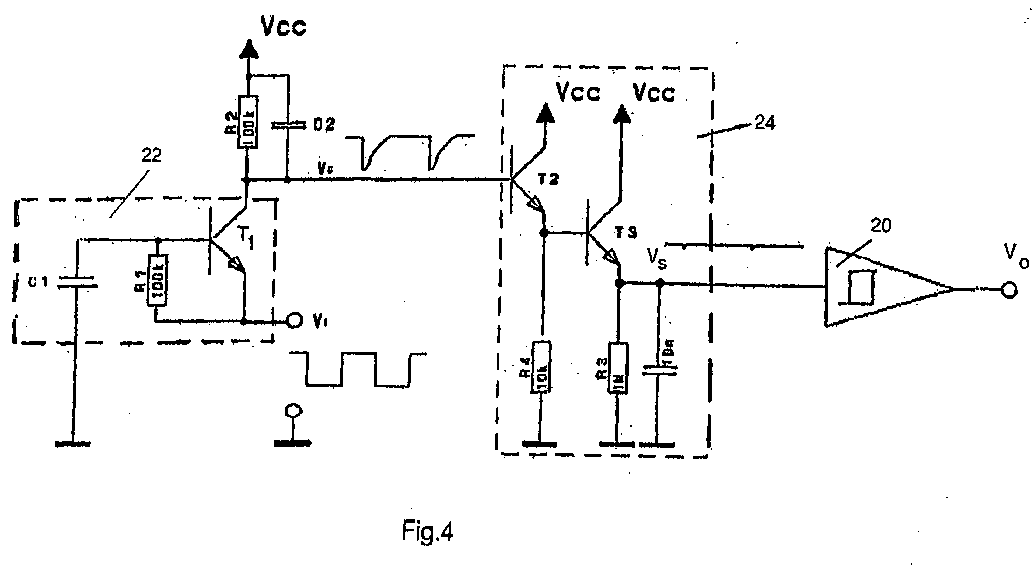

Die Basis des Transistors $T_1$ ist über einen Widerstand $R_1$ mit dem Emitter des Transistors $T_1$ verbunden. Der Kollektor des Transistors $T_1$ liegt über einen Widerstand $R_2$ an einer Spannung $V_{cc}$. Am Emitter des Transistors ist eine Rechteckimpulsspannung von z.b. 5 V angelegt. Mit dieser Spannung wird der Kondensator $C_1$ über den Widerstand $R_1$ aufgeladen, wobei der Transistor $T_1$ während der Aufladung gesperrt ist. Beim Erreichen der steilen Nachlaufflanke der angelegten Rechteckspannung wird das Emitterpotential des Transistors $T_1$ augenblicklich auf Masse gelegt. Hierdurch ergibt sich eine positive Potentialdifferenz zwischen Basis und Emitter, und der Transistor $T_1$ schaltet durch, wodurch sich am Kollektor eine negative Spannungsspitze ergibt, und der Kondensator $C_1$ wird über die Parallelschaltung von $R_1$ und die Basisemitterstrecke des Transistors $T_1$ entladen. Je größer der Kapazitätswert von $C_1$ (Berührung durch den Finger 18), umso tiefer und breiter wird dieser negative Spannungsimpuls, wie dies in Fig. 3 dargestellt ist. Dieser Spannungsimpuls (Kollektorspannung $V_c$) wird einer Triggerschaltung 20 zugeführt, die eine Ausgangsspannung $V_0$ liefert, wenn die negative Spannungsspitze $V_c$ einen vorbestimmten Schwellenwert unterschreitet. Dieser Schwellenwert kann fest eingestellt sein, oder er kann, wie weiter unten in Verbindung mit Fig. 4 beschrieben wird, selbsteinstellend sein, um die durch Umgebungsbedingungen sich ändernden Kapazitätswerte von $C_{ku}$ und $C_{su}$ zu berücksichtigen.

Fig. 3 veranschaulicht die Signale, die sich bei betätigter Taste und bei nicht betätigter Taste ergeben. Fig. 3a zeigt einen positiven Spannungimpuls, der am Emitter des Transistors $T_1$ anliegenden Rechtecksteuerspannung. Aus den Darstellungen gemäß Fig. 3b und 3c ergibt sich die Änderung der Kollektorspannung $V_c$ des Transistors bei nicht betätigter Taste (3b) und bei betätigter Taste (3c). Bei nicht berührter Taste gemäß Fig. 3b ist zwar wegen der vorhandenen Kapazitäten eine negative Spannungsspitze von $V_c$ vorhanden, jedoch erreicht diese nicht den Schwellenwert Sw. Bei Berührung wird dieser Schwellenwert Sw erreicht, und die Triggerschaltung 20 liefert ein Ausgangssignal $V_0$, welches den Berührungszustand anzeigt. Dieser Ausgangsimpuls ist in Fig. 3d dargestellt, und dieser Impuls endet, sobald $V_c$ wieder so weit angestiegen ist, daß die Triggerschaltung 20 ein Null-Ausgangssignal liefert. Der Ausgangsimpuls gemäß Fig. 3d ergibt sich natürlich nur bei betätigter Taste gemäß Fig. 3c, aber nicht bei nicht betätigter Taste gemäß Fig. 3b.

Fig. 4 zeigt eine Schaltung, mit der die sich zeitlich und räumlich ändernden Faktoren, die die Gesamtkapazität bei Nichtberührung beeinflussen, berücksichtigt werden können. Diese Faktoren sind u.a. die normalen Wertestreuungen und die Temperaturabhängigkeit der elektronischen Bauteile, und diese führen dazu, daß die Impulshöhen zwischen verschiedenen Tasten einer Tastatur und mit zeitlicher und räumlicher Gegebenheit variieren können. Die Schaltung gemäß Fig. 4 ermöglicht es, den Schwellenwert nach den jeweiligen Gegebenheiten "schwimmend" festzulegen.

Der strichliert umschlossene Schaltungsteil 22 in Fig. 4 umfaßt das Sensorelement gemäß Fig. 2. Gemäß dem Ausführungsbeispiel haben die Widerstände $R_1$ und $R_2$ einen Wert von 100 kΩ. Parallel zum Widerstand $R_2$ ist ein Kondensator $C_2$ als Störfilter geschaltet.

Der andere strichlierte Schaltungsteil in Fig. 4 zeigt eine Scheitelwertmessung. Der Kollektor des Transistors $T_1$, an dem das Ausgangssignal $V_c$ abgenommen wird, ist mit der Basis eines Transistors $T_2$ verbunden, dessen Emitter über einen Widerstand $R_4$ von 10 kΩ an Masse gelegt ist. Der Emitter des Transistors $T_2$ ist mit der Basis eines weiteren Transistors $T_3$ verbunden, dessen Emitter über einen Widerstand $R_3$ von 1 MegΩ an Masse gelegt ist. Parallel zu dem Widerstand $R_3$ liegt ein Kondensator $C_3$ mit 10 nF, der eine Speicherung der Spitzenspannungswerte bewirkt. Vom Emitter des Transistors $T_3$ wird der Spitzenspannungs-

wert $V_s$ abgenommen und an eine Triggerschaltung oder einen Microcontroller weitergegeben.

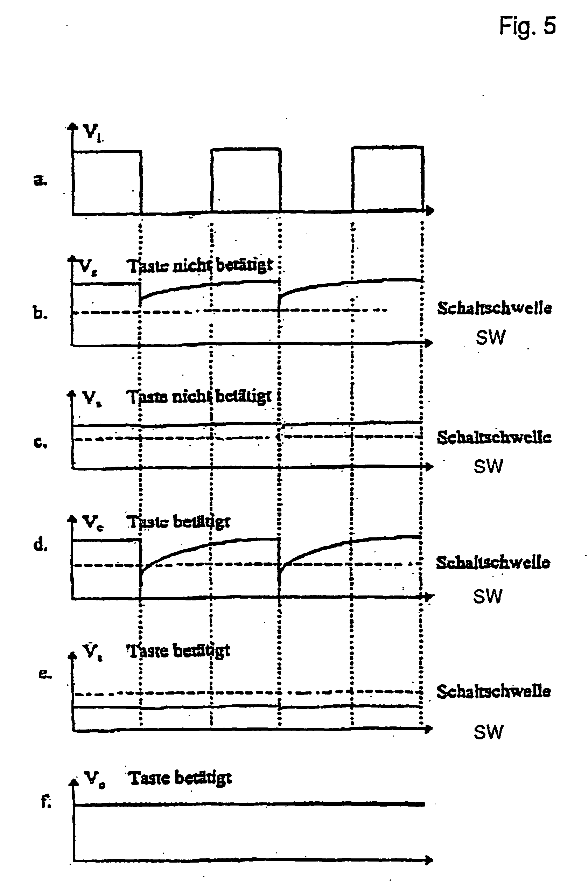

Die Impulshöhe wird durch die als Spitzenspannungsmesser wirkenden Transistoren $T_2$ und $T_3$ gemessen und am Kondensator $C_3$ gespeichert. Diese festgehaltene Impulshöhe wird mit einem vorbestimmten Schwellenwert an der Triggerschaltung 20 verglichen. Ist die Taste nicht betätigt, erreicht die festgehaltene Impulshöhe den Schwellenwert nicht und somit ergibt sich keine Ausgangsspannung $V_0$ (=0). Ist die Taste betätigt, unterschreitet die festgehaltene Impulshöhe den Schwellenwert und die Schwellenschaltung 20 eine Ausgangsspannung $V_0$ (=5V). Diese Vorgänge sind in Fig. 5 dargestellt.

Die festgehaltene Impulshöhe kann aber zugleich als Kompensation an den Schwellenwert durch Analogschaltungstechnik oder Software-Algorithmus wirken, so daß der Schwellenwert ständig an die "langsam" veränderte Impulshöhe - bedingt durch die räumlich und zeitlich variierenden Faktoren - angepaßt wird, d.h. eine "schwimmende" Schaltschwelle.

Wenn anstelle der Triggerschaltung 20 ein Microcontroller mit Analogeingang verwendet wird, so kann die Auswertung des Triggervorgangs mit Schwellenwertkompensation komplett durch Software ohne zusätzlichen Schaltungsaufwand erfolgen.

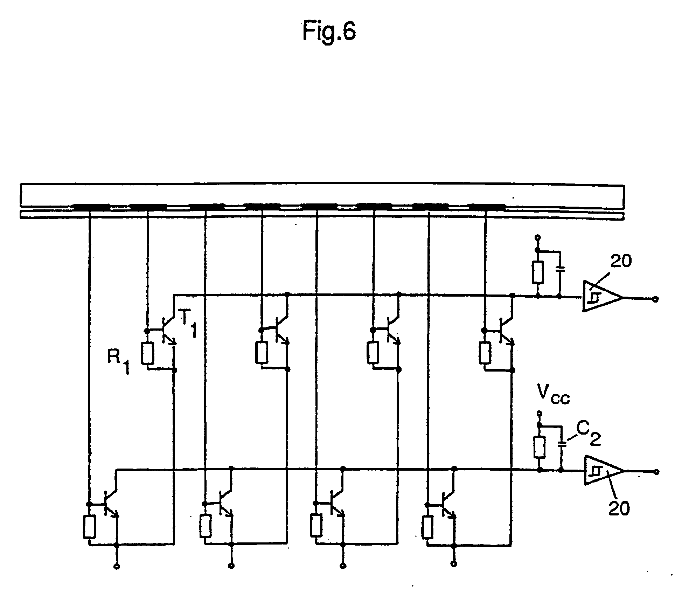

Fig. 6 zeigt eine Schaltungsanordnung eines Multiplexverfahrens, mit der eine größere Zahl von Tasten mit niedrigem Schaltungsaufwand zusammengefaßt werden können.

Zur Funktionsbeschreibung des erfindungsgemäßen Berührungssensors sollen zunächst die äußeren beeinflussenden Faktoren außer acht gelassen werden, und es soll der Kondensator $C_1$ als ein Plattenkondensator zwischen dem menschlichen Körper und der Elektrode 12 angesehen werden. Dieser Kondensator $C_1$ läßt sich in folgender Funktion darstellen:

$$C_1 = 10^{12} {}^* \varepsilon_0 {}^* \varepsilon_r {}^* F/d$$

Dabei ist $\varepsilon_0$ die absolute Dielektrizitätskonstante und $\varepsilon_r$ die relative Dielektrizitätskonstante des Mediums zwischen dem Finger 18 und der Elektrode; F ist die vom Finger berührte Plattenfläche und d ist die Dicke der Platte 10.

Am Emitter des Transistors $T_1$ wird eine Rechteckspannung von z.B. 5 V angelegt. Während der positiven Phase wird der Kondensator $C_1$ über den Widerstand $R_1$ aufgeladen. Dabei ist der Transistor $T_1$ gesperrt. Mit der abfallenden Flanke wird das Emitterpotential plötzlich an Masse gelegt. Da sich das Potential des Kondensators nicht rasch ändern kann, entsteht in diesem Moment eine positive Potentialdifferenz zwischen Basis und Emitter. Der Transistor $T_1$ wird leitend, und am Kollektor entsteht ein Impuls (Fig. 3d) in Form einer negativen Spannungespitze. Je größer $C_1$ ist, um so tiefer und breiter wird dieser Impuls. Dieser Spannungsimpuls $V_c$ entsteht wegen der Umgebungskapazitäten auch ohne Berührung der Sensorfläche, und es wird ein Ausgangssignal nur dann erzeugt, wenn diese negative Spannungsspitze einen vorbestimmten Schwellenwert überschreitet. Dieser Schwellenwert kann über einen Komparator fest eingestellt werden (Fig. 1, 2), der Schwellenwert kann jedoch auch zur Berücksichtigung von Kapazitätsänderungen der Umgebung schwimmend festgelegt werden (Fig. 4).

Bezugszeichenliste

| | |
|---|---|
| 10 | Glasplatte |
| 12 | Elektrode |
| 14 | Leiterplatte |
| 16 | Sensorfläche |
| 18 | Finger |
| 20 | Triggerschaltung |
| 22 | Schaltungsteil |
| 24 | Scheitelwertmesser |

**Patentansprüche**

1. Schaltungsanordnung für einen kapazitiven Berührungssensor mit den folgenden Merkmalen:

   - eine Elektrode (12) auf einer Sensorplatte (10) ist mit der Basis eines Transistors (T1) verbunden;
   - ein Widerstand (R1) liegt parallel zur Basis-Emitterstrecke des Transistors (T1);
   - der Kollektor des Transistors (T1) liegt über einen Widerstand (R2) an Spannung (Vcc);
   - der Kollektor des Transistors (T1) ist an eine Auswerteschaltung (20) angeschlossen;
   - am Emitter des Transistors (T1) liegt eine Impulsspannung;

   wobei

   - die am Emitter des Transistors liegende Impulsspannung eine periodische Rechteckspannung ist;
   - während der positiven Phase der periodischen Rechteckspannung die Gesamtkapazität (12) auf die Amplitude der Rechteckspannung aufgeladen wird, während der Transistor (T1) gesperrt ist;
   - die steile Nachlaufflanke der Rechteckspannung periodisch den Emitter des Transistors (T1) auf Masse zieht, eine positive Spannungsdifferenz zwischen Basis und Emitter erzeugt, den Transistor dadurch durchschaltet und somit periodisch eine negative Spannungsspitze ($V_c$) am Kollektor erzeugt;

- die Auswerteschaltung (20) einen Schwellwertschalter aufweist, dessen Schwellwert (SW) so eingestellt wird, dass dieser durch die negative Spannungsspitze ($V_c$) erst bei Erreichen eines vorbestimmten durch Berührung der Sensorplatte (10) erhöhten Kapazitätswertes überschritten wird und ein Schaltsignal auslöst,

- die Spannungsspitzen ($V_c$) durch als Spitzenspannungsmesser wirkende Transistoren ($T_2$) und ($T_3$) gemessen und an einem Kondensator (C3) gespeichert werden, und die gespeicherte Spannungsspitze mit dem jeweils gültigen Schwellwert an der Auswerteschaltung (20) verglichen wird, wobei eine rasche, den Schwellwert überschreitende Spitzenspannungsänderung das Schaltsignal auslöst und eine langsame Spitzenspannungsänderung den Schwellwert anpaßt,

- der Schwellwert in Abhängigkeit von den sich ändernden Umgebungs-Kapazitätsverhältnissen dadurch einstellbar wird, dass die gemessenen Spannungsspitzen ($V_c$) den Schwellwert über einen Software-Algorithmus kompensieren, so dass der Schwellwert ständig an die sich langsam verändernden Spannungsspitzen - bedingt durch die räumlich und zeitlich variierenden Faktoren - angepaßt wird.

ter, thereby switches over the transistor and thus periodically generates a negative voltage peak ($V_c$) at the collector;

- the evaluating circuit (20) incorporates a critical value switch, the critical value (SW) of which is adjusted so that it is only exceeded by the negative voltage peak ($V_c$) once a predetermined capacitance level raised by touching the sensor plate (10) is reached and triggers a switching signal,

- the voltage peaks ($V_c$) are measured by transistors (T2) and (T3) acting as peak-voltage meters and stored at a capacitor (C3), and the stored voltage peak is compared with the respectively applying critical value at the evaluating circuit (20), and a rapid change in peak voltage that exceeds the critical value triggers the switching signal and a slow change in peak voltage adapts the critical value,

- the critical value can be adjusted in dependence on the changing ambient capacitance conditions by virtue of the measured voltage peaks ($V_c$) compensating for the critical value via a software algorithm, with the result that the critical value is continually adapted to the slowly changing peak voltages - as dictated by the spatially and temporally varying factors.

## Claims

1. Circuit arrangement for a capacitive contact sensor having the following features:

   - an electrode (12) on a sensor plate (10) is connected to the base of a transistor (T1);
   - a resistor (R1) is connected parallel to the base-emitter section of the transistor (T1);
   - the collector of the transistor (T1) is connected to the supply (Vcc) via a resistor (R2);
   - the collector of the transistor (T1) is linked to an evaluating circuit (20);
   - there is a pulse voltage across the emitter of the transistor (T1);

   **characterised in that**

   - the pulse voltage across the emitter of the transistor is a periodic square-wave voltage;
   - during the positive phase of the periodic square-wave voltage the overall capacitance (12) is charged to the square-wave voltage's amplitude, whereas the transistor (T1) is disabled;
   - the steep trailing edge of the square-wave voltage periodically draws the emitter of the transistor (T1) to frame, generates a positive voltage differential between the base and the emit-

## Revendications

1. Circuit pour un capteur de contact capacitif présentant les caractéristiques suivantes :

   - une électrode (12) située sur une plaque de capteur (10) est reliée à la base d'un transistor ($T_1$);
   - une résistance $R_1$ est branchée en parallèle sur la liaison base-émetteur du transistor ($T_1$);
   - le collecteur du transistor ($T_1$) est mis à la tension ($V_{cc}$) par l'intermédiaire d'une résistance ($R_2$);
   - le collecteur du transistor ($T_1$) est relié à un circuit d'évaluation (20);
   - une tension pulsée est appliquée à l'émetteur du transistor ($T_1$);

   dans lequel

   - la tension pulsée appliquée à l'émetteur du transistor ($T_1$) est une tension rectangulaire périodique ;
   - pendant la phase positive de la tension rectangulaire périodique, la capacité totale (12) est chargée à l'amplitude de la tension rectangulaire tandis que le transistor ($T_1$) est bloqué ;
   - le flanc raide descendant de la tension rectangulaire met périodiquement l'émetteur du tran-

sistor ($T_1$) à la masse, génère une différence de tension positive entre base et émetteur, rend de ce fait le transistor conducteur et génère ainsi périodiquement une crête de tension négative ($V_c$) au collecteur ;

- le circuit d'évaluation (20) présente un commutateur à valeur seuil dont la valeur seuil (SW) est réglée de telle manière qu'elle n'est dépassée par la crête de tension négative ($V_c$) et ne déclenche un signal de commutation qu'à l'atteinte d'une valeur de capacité prédéfinie augmentée par contact avec la plaque de capteur (10) ;

- les crêtes de tension ($V_c$) sont mesurées par des transistors ($T_2$) et ($T_3$) fonctionnant en voltmètre de crête et accumulées sur un condensateur ($C_3$), et la crête de tension est comparée avec la valeur seuil respectivement valide dans le circuit d'évaluation (20), une variation de tension de crête rapide, dépassant la valeur seuil, déclenchant le signal de commutation et une variation de tension de crête lente adaptant la valeur seuil ;

- la valeur seuil est réglable en fonction des conditions de capacité ambiante variables par le fait que les crêtes de tension ($V_c$) mesurées compensent la valeur seuil par l'intermédiaire d'un algorithme logiciel de telle manière que la valeur seuil est adaptée en permanence aux crêtes de tension variables lentement sous l'influence des facteurs variables dans l'espace et dans le temps.

Fig.1

Fig.2

Fig.3

a.

$V_I$

b.

$V_c$    Taste nicht betätigt

SW

c.

$V_c$    Taste betätigt

SW

d.

$V_o$

Fig.4

Fig. 5

a.

$V_i$

b.

$V_c$  Taste nicht betätigt

Schaltschwelle

SW

c.

$V_i$  Taste nicht betätigt

Schaltschwelle

SW

d.

$V_c$  Taste betätigt

Schaltschwelle

SW

e.

$V_i$  Taste betätigt

Schaltschwelle

SW

f.

$V_o$  Taste betätigt

Fig.6